# EUROPEAN PATENT APPLICATION

(11) **EP 3 007 356 A1**
(43) Date of publication of application: **13.04.2016**
(21) Application number: 14464012.5
(22) Date of filing: 10.10.2014
(51) Int. Cl.: H03G 3/02, H03G 11/00

(54) **Vehicle audio system with configurable maximum volume output power**

(71) Applicant: Continental Automotive GmbH, 30165 Hannover (DE)
(72) Inventor: Poiana, Mircea, 300576 Timisoara (RO)

(57) **Abstract**

A vehicle audio system (100) is presented, comprising a user interface unit (101) and a volume control unit (104). The volume control unit is configured to store a first maximum volume level (201). The user interface unit (101) is configured to allow setting a second maximum volume level (203) that is less than or equal to the first maximum volume level (201). The volume control unit (104) is configured to limit a volume level of an audio signal of the vehicle audio system (100) to the second maximum volume level (203).

## Description

### Technical field

The present invention relates to a vehicle audio system. In particular, the present invention relates to a vehicle audio system, a method for operating a vehicle audio system, a program element, and a computer-readable medium.

### Background of the invention

A vehicle audio system, for example a car audio system, refers to a system that allows user to listen to powerful sound by enhancing the performance of audio elements such as a head unit, an amplifier and a speaker, compared to a home audio system. The range of the vehicle's audio system volume output power, however, may not always be customized to the user's desire for comfort. For example, for certain automobile models, already at volume level 1, i.e. at the minimum volume level, the sound may be considered to be too loud for some users. Further, the range of the volume output from the audio system may not reflect the capabilities of the speakers, thus leading to an output power that can exceed the speaker's capabilities.

### Summary of the invention

It is an object of the invention to provide a vehicle audio system which provides improved user comfort.

This object and further objects are achieved by the subject-matter of the independent claims. Further embodiments and advantages are set out in the respective dependent claims and the following description of exemplary embodiments.

A first aspect of the invention relates to a vehicle audio system comprising a user interface and a volume control unit. The volume control unit is configured to store a first maximum volume level of an audio signal of the vehicle audio system. The user interface unit is configured to allow setting a second maximum volume level of the audio signal. The second maximum volume level is less than or equal to the first maximum volume level. The volume control unit is configured to limit a volume level of the audio signal to the second maximum volume level.

The vehicle audio system may be a part of a vehicle infotainment system and provide a user, such as a driver and/or a passenger, with an audio program from different resources. For example, the vehicle audio system may allow program inputs from AM radio, FM radio or the like. In another example, an integrated audio player entertains the user with audio CDs and MP3/WMA CDs. In another example, the user may select external data storage devices, e.g. iPod, MP3 player or USB stick, or a portable CD player to connect to the vehicle audio system as further audio sources. In another example, the vehicle audio system can be equipped with a mobile phone portal that provides the user with the possibility of having mobile phone conversations via a vehicle microphone and the vehicle loudspeakers. In a further example, the vehicle audio system is connected to a navigation system with dynamic route planning for guiding the user to the destination.

The first maximum volume level may be preset by the automobile manufacturers. On the other hand, the second maximum volume level, which is less than or equal to the first maximum volume level, is determined by a user, such as a driver and/or a passenger, by using a user interface unit. The second maximum volume level determines the maximum output power of the vehicle audio system.

The vehicle audio system is operated using the user interface unit. In an example, the user interface unit is provided as a multifunctional knob. For example, the user can turn the multifunctional knob to adjust the output volume level. The maximum volume level may be selected by pressing the multifunctional knob. Alternatively to a multifunctional knob, steering wheels or buttons can also be used as the user interface unit. In another example, the user interface unit is provided as a touch screen. The user can adjust the output volume and set the maximum volume level through simple or multi-touch gestures by touching the screen with a special stylus/pen and/or one or more fingers. In another example, the user interface unit is provided as a speech recognition device. The speech recognition device enables the adjustment of the volume levels via voice input, such as commands or numeric sequences.

The user may also determine the volume distribution in the vehicle by setting the second maximum volume level, i.e. the desired maximum volume level, differently, for example, between the front and rear speakers in the vehicle and/or between the left and right speakers in the vehicle so as to achieve an audio fade control and/or an audio balance control.

The user may also set the second maximum volume level according to audio resources. For example, the user may set the second maximum volume level, i.e. the desired maximum volume level, differently for e.g. traffic announcement, chime volume or beeping sounds, navigation volume, etc.

According to the setting, the volume control unit limits a volume level of an audio signal to the second maximum volume level so that the range of the vehicle's audio system volume output power is customized to the user's desire for comfort.

The user interface unit may be connected to the volume control unit by an internal communication unit of the vehicle, for example, GSM, Wi-Fi device, Bluetooth device, or other wireless connections. Alternatively, the connection may be achieved via an electrical line and/or via fibre optics.

According to an exemplary embodiment of the invention, the second maximum volume level is divided into a range of at least two second volume steps.

In an example, the first maximum volume level is divided into two first volume steps that may be labeled as "low" and "high". In another example, the first maximum volume level is divided into three first volume steps that may be labeled as "low", "medium" and "high". In another example, the maximum volume level is divided into more than three first volume steps, for example 10, 20, 40 or a different value.

According to an exemplary embodiment of the invention, the number of the second volume steps is constant.

For example, the number of the second volume steps is preset by the automobile manufacturer. In another example, the number of the second volume steps is determined by a user by using the user interface unit.

According to an exemplary embodiment of the invention, the first maximum volume level is divided into a range of at least two first volume steps. The number of the second volume steps is equal to the number of the first volume steps.

Similar to the second maximum volume level, the first volume level may also be divided into a range of at least two first volume steps, such as two, three, ten or forty first volume steps. The number of the second volume steps may be set equal to the number of the first volume steps. That is to say that the number of the second volume steps is also set to two, three, ten or forty, accordingly. Alternatively, the user may also determine the number of the second volume steps by using the user interface unit.

According to an exemplary embodiment of the invention, the user interface unit is configured to allow setting the output volume level to one of the at least two second volume steps. The volume control unit is configured to control the audio signal at the output volume level.

For example, the second maximum volume level is divided into three second volume steps that are labeled as "low", "medium" and "high". The user may select one of the steps as an output volume level by using the user interface unit.

In another example, the output volume level is adapted automatically to make up for the road and wind noise as the user drives. For example, the output volume level increases accordingly with the noise level of the road and wind.

As an advantage, even if at volume 1, i.e. the minimum volume level, of the first volume steps, the sound is considered to be too loud and thus causes discomfort to a user. It is still possible to set the volume 1 as the second maximum volume level, i.e. the desired maximum volume level, and further divide the second maximum volume level into a range of second volume levels, such as "low", "medium" and "high". As a result, the user can select an output volume level, for example "low" so that a "softened" output volume level is achieved and the user comfort is improved.

According to an exemplary embodiment of the invention, the user interface unit comprises a display unit. The display unit is configured to display at least one of the group comprising the first maximum volume level, the at least two first volume steps, the second maximum volume level, the at least two second volume steps and the output volume level.

For example, the display unit is a LED display, a LCD display or other display devices. The user interface unit may also be integrated into the display unit to form a touch screen. The display unit may also serve as the primary display screen of a video device such as a television or DVD player. The display unit may simply show numeric values that represent at least one of the group comprising the first maximum volume level, the at least two first volume steps, the second maximum volume level, the at least two second volume steps and the output volume level. In another example, the display unit provides a graphic indication of the above-mentioned parameters.

By using the display unit, the user can control the vehicle audio system easily and intuitively.

Another aspect of the invention relates to a method for operating a vehicle audio system. The method comprises the step of setting a first maximum volume level of an audio signal of the vehicle audio system. Moreover, the method comprises the step of setting a second maximum volume level of the audio signal, wherein the second maximum volume level is less than or equal to the first maximum volume level. Furthermore, the method comprises the step of limiting a volume level of the audio signal the second maximum volume level.

The method further comprises the step of displaying at least one of the group comprising the first maximum volume level, the at least two first volume steps, the second maximum volume level, the at least two second volume steps and the output volume level.

This method can, for example, be carried out by a vehicle audio system described in the context of the present invention. Features and advantages that are described with respect to the vehicle audio system can also apply to the method. The steps of the method can be executed in the order presented. Moreover, the steps of the method can be carried out in another order or parallel to each other.

Therefore, it may be seen as a gist of the invention to allow the user to select the maximum volume level of a vehicle audio system. The user may also select the number of volume steps for the new volume output power interval. For example, if the maximum volume level is preset by auto manufacturers and it is divided into a range of 0 to 40 volume steps, the user may select the value 16 as the maximum volume output power and further create 40 volume steps for the 0 to 16 interval. By redefining new maximum volume level and new volume steps, a "softened" and "comfortable" sound is achieved, particularly in view of the fact that the minimum volume level of certain automobile models is already considered to be too loud for some users. In this way, the range of the vehicle's audio system volume output power is customized to the user's desire for comfort.

Another aspect of the invention relates to a program element, which, when it is processed by a processor, instructs the processor to carry out a method that is described in the context of the present invention.

The computer program element might therefore be stored on a computer unit, which might also be part of an embodiment of the present invention. This computing unit may be adapted to perform or induce a performing of the steps of the method described above. Moreover, it may be adapted to operate the components of the above described apparatus. The computing unit can be adapted to operate automatically and/or to execute the orders of a user. A computer program may be loaded into a working memory of a data processor. The data processor may thus be equipped to carry out the method of the invention.

This exemplary embodiment of the invention covers both, a computer program that right from the beginning uses the invention and a computer program that by means of an up-date turns an existing program into a program that uses the invention.

Further on, the computer program element may be adapted to provide all necessary steps to fulfil the procedure of an exemplary embodiment of the method as described above.

Another aspect of the invention relates to a computer-readable medium, on which a program element is stored, which, when it is processed by a processor, instructs the processor to carry out a method that is described in the context of the present invention.

A computer program may be stored and/or distributed on a suitable medium, such as an optical storage medium or a solid state medium supplied together with or as part of other hardware, but may also be distributed in other forms, such as via the internet or other wired or wireless telecommunication systems.

However, the computer program may also be presented over a network like the World Wide Web and can be downloaded into the working memory of a data processor from such a network. According to a further exemplary embodiment of the present invention, a medium for making a computer program element available for downloading is provided, which computer program element is arranged to perform a method according to one of the previously described embodiments of the invention.

It has to be noted that embodiments of the invention are described with reference to different subject matters. In particular, some embodiments are described with reference to method type claims whereas other embodiments are described with reference to the device type claims. However, a person skilled in the art will gather from the above and the following description that, unless otherwise notified, in addition to any combination of features belonging to one type of subject matter also any combination between features relating to different subject matters is considered to be disclosed with this application. However, all features can be combined providing synergetic effects that are more than the simple summation of the features.

While the invention has been illustrated and described in detail in the drawings and foregoing description, such illustration and description are to be considered illustrative or exemplary and not restrictive. The invention is not limited to the disclosed embodiments. Other variations to the disclosed embodiments can be understood and effected by those skilled in the art in practicing a claimed invention, from a study of the drawings, the disclosure, and the dependent claims.

### Brief description of the drawings

Exemplary embodiments of the invention will be described in the following drawings. Any reference signs in the claims should not be construed as limiting the scope of the claims. The drawings may be schematic and not true to scale.
Fig. 1 shows a vehicle audio system according to an exemplary embodiment of the invention.
Fig. 2 shows a visual indication on a display unit according to an exemplary embodiment of the invention.
Fig. 3 shows a flow-chart of a method according to an exemplary embodiment of the invention.

### Detailed description of exemplary embodiments

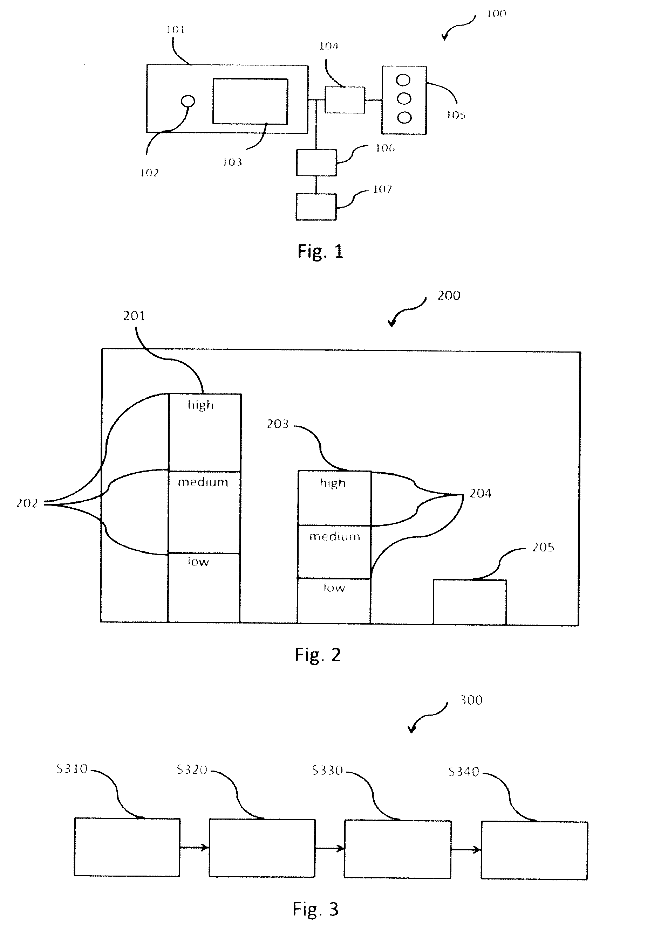

Fig. 1 shows a vehicle audio system 100 according to an exemplary embodiment of the invention. The vehicle audio system comprises a user interface unit 101, a volume control unit 104, a set of audio speakers 105 a CPU 106 and a computer-readable medium 107. The user interface unit 101 is provided as a knob 102. The user interface unit 101 further comprises a display unit 103.

The vehicle audio system 100 may be a part of a vehicle infotainment system that for example integrates a vehicle's audio, navigation, communication, and climate systems and delivers entertainment and information content. The vehicle audio system 100 may thus have audio programs from different resources. For example, the vehicle audio system may allow program inputs from AM radio, FM radio or the like. The user may also play audio CDs and MP3/WMA CDs on an integrated audio player. External data storage devices, e.g. iPod, MP3 player or USB stick, or a portable CD player may also be connected to the vehicle audio system as further audio sources. In another example, the vehicle audio system can be equipped with a mobile phone portal that provides the user with the possibility of having mobile phone conversations via a vehicle microphone and the vehicle loudspeakers. To be able to use the Phone portal, the mobile phone may be connected with it via Bluetooth or in-vehicle Wi-Fi. In a further example, the vehicle audio system is connected to a navigation system with dynamic route planning for guiding the user to the destination.

The user interface unit 101 is configured to adjust the volume level of the vehicle audio system 100, for example, by turning the knob 102. The user may also determine the maximum volume level by pressing the knob 102. Alternatively to the knob 102, steering wheels or buttons may also be used for the adjustment. In addition, the user interface unit 101 may also be provided as a touch screen. The adjustment can be achieved by touching the screen with a special stylus/pen and/or one or more figures through simple or multi-touch gestures. In another example, the user interface unit 101 may be provided as a speech recognition device that enables the user to operate various functions of the vehicle audio system 100 via voice input.

The display unit 103 is provided as a visual indication of the parameters comprising a first maximum volume level, at least two first volume steps, a second maximum volume level, at least two second volume steps and an output volume level, thus making the adjustment process easily and intuitively. The display may also be provided as a touch screen for the achievement of the volume control. In this case, the knob 102 is not required.

The user interface unit 101 may be connected to the volume control unit 104 via wireless connections, such as GSM, Wi-Fi, or Bluetooth, or via an electrical line or fibre optics.

The volume control unit 104 is configured to limit a volume level of an audio signal of the vehicle audio system 100 to the maximum volume level input by the user via the user interface unit 101.

A set of audio speakers 105 is controlled by the volume control unit 104. The set of audio speakers 105 may comprises one or a plurality of audio speakers. For example, the set of audio speakers 105 may be provided as front and rear speakers in a vehicle to achieve an audio fade effect and/or as left and right speakers in the vehicle to achieve an audio balance effect. In another example, the set of audio speakers 105 may comprise wired or wireless headphones. The output power of the set of audio speakers 105 is limited by the maximum volume level input by the user.

The maximum volume level may also be set differently for the set of audio speakers 105, for example in order to achieve a desired volume distribution in the vehicle. An example is to set the maximum volume level differently between the front and rear speakers in the vehicle to achieve an audio fade control. Another example is to set the maximum volume level differently between the left and right speakers in the vehicle so as to achieve a balance control.

Moreover, the maximum volume level may be set differently for different audio resources. For example, the user may set the maximum volume level differently for e.g. traffic announcement, chime volume or beeping sounds, navigation volume, etc.

The CPU 106 is configured to carry out a method shown in Fig. 3 under the instruction of a computer program that may be stored on the computer-readable medium 107, such as an optical storage medium or a solid state medium.

Fig. 2 shows a visual indication on a display unit 200 according to an exemplary embodiment of the invention. The display unit 200 provides a graphic indication of a first maximum volume level 201, three first volume steps 202, a second maximum volume level 203, three second volume steps 204 and an output volume level 205.

The first maximum volume level 201 may be preset by the automobile manufacturer that is further divided into three first volume steps 202. The three first volume steps are labeled as "low", "medium" and "high", respectively. It must be noted that the three volume steps are to be considered illustrative. The number of the volume steps may also be 10, 20, 40 or a different value.

If the first maximum volume level 201 is considered to be too loud, a desired maximum volume level can be reset by the user. The user may set the desired maximum volume, i.e. a second maximum volume level 203, by selecting a volume step from the first volume steps 202 by using the user interface unit 101, e.g. by turning the knob 102. In Fig. 2, the desired maximum volume level 203 is determined by selecting a volume step "medium" of the three first volume steps 202. Alternatively, the user may simply set the second maximum volume level 203 arbitrarily without using the first volume steps 202.

The second maximum volume level 203 is further divided into three second volume steps that are also labeled as "low", "medium" and "high". In Fig. 2, the number of the second volume steps 204 is equal to the number of the first volume steps 202. However, the number of the first and second volume steps may also be different. For example, the number of the volume steps 202, 204 may be determined by the user via the user interface 101. The second volume steps 204 allows a fine tuning of the output volume level 205. For example, the output volume level 205 is selected as the volume step "low" of the second volume steps 204. The output volume level 205 determines the output volume power of the vehicle audio system 100.

To adjust the volume distribution between the front and rear speakers and/or between the left and right speakers in the vehicle, the output volume level 205 may also be adjusted separately for the front, rear, left and/or right speakers in the vehicle.

In addition, the output volume level 205 may also be adjusted automatically, e.g. to make up for the road and wind noise as the user drives. For example, the output volume level increases accordingly with the noise level of the road and wind.

By adjusting the maximum volume level that is less than or equal to the maximum volume level preset by the automobile manufacturers, the user can obtain a "softened" sound that improves the user comfort. In addition, even if the minimum volume level, e.g. the volume step "low" in the first volume steps 202, is too loud, the user may set the minimum volume level as the second maximum volume level 203 and further divided the maximum volume level 203 into a plurality of the second volume steps 204. In this way, the user can reduce the volume level of the audio system, thus eliminating or reducing unpleasant surprise and discomfort caused by the loud minimum volume level preset by the automobile manufacturers.

Fig. 3 shows a flow-chart of a method 300 according to an exemplary embodiment of the invention. The method 300 comprises the step S310 of setting a first maximum volume level. Moreover, the method comprises the step S320 of setting a second maximum volume level that is less than or equal to the first maximum volume level. Furthermore, the method comprises the step S330 of limiting a volume level of an audio signal of the vehicle audio system to the second maximum volume level.

The method further comprises the step S340 of displaying at least one of the group comprising the first maximum volume level, the at least two first volume steps, the second maximum volume level, the at least two second volume steps and the output volume level.

In the claims, the word "comprising" does not exclude other elements or steps and the indefinite article "a" or "an" does not exclude a plurality. It has to be noted that features which are described with reference to an exemplary embodiment may also be combined with other features of other exemplary embodiments. The mere fact that certain measures are recited in mutually different dependent claims and/or exemplary embodiments does not indicate that a combination of these measures cannot be used to advantage. The reference numerals in the claims are not intended to restrict the scope of the claims.

## Claims

1. A vehicle audio system (100), comprising:
a user interface unit (101);
a volume control unit (104);
wherein the volume control unit is configured to store a first maximum volume level (201) of an audio signal of the vehicle audio system (100);
wherein the user interface unit (101) is configured to allow setting a second maximum volume level (203) of the audio signal by a user; wherein the second maximum volume level (203) is less than or equal to the first maximum volume level (201); and
wherein the volume control unit (104) is configured to limit a volume level of the audio signal to the second maximum volume level (203).

2. Vehicle audio system (100) according to claim 1,
wherein the second maximum volume level (203)is divided into a range of at least two second volume steps (204).

3. Vehicle audio system (100) according to claim 2,
wherein the number of the second volume steps (204) is constant.

4. Vehicle audio system (100) according to claim 3,
wherein the first maximum volume level (201) is divided into a range of at least two first volume steps (202); and
wherein the number of the second volume steps (204) is equal to the number of the first volume steps (202).

5. Vehicle audio system according to one of the preceding claims 2 to 4,
wherein the user interface unit (101) is configured to allow setting the output volume level (205) to one of the at least two second volume steps (204); and
wherein the volume control unit (104) is configured to control the audio signal at the output volume level (205).

6. Vehicle audio system (100) according to any one of the preceding claims,
wherein the user interface unit (101) comprises a display unit (103); and
wherein the display unit (103) is configured to provide a visual indication of at least one of the group comprising the first maximum volume level (201), the at least two first volume steps (202), the second maximum volume level (203), the at least two second volume steps (204) and the output volume level (205).

7. A method (300) for operating a vehicle audio system, comprising the following steps:
a) setting (S310) a first maximum volume level of an audio signal of the vehicle audio system;
b) setting (S320) a second maximum volume level of the audio signal; wherein the second maximum volume level is less than or equal to the first maximum volume level;
c) limiting (S330) a volume level of the audio signal to the second maximum volume level.

8. Method according to claim 7, further comprising:
displaying (S340) at least one of the group comprising the first maximum volume level, the at least two first volume steps, the second maximum volume level, the at least two second volume steps and the output volume level.

9. Program element, which, when it is carried out by a processor (106), instructs the processor to carry out a method according to claim 7 or 8.

10. Computer-readable medium (107) on which a program element is stored, which, when it is carried out by a processor (106), instructs the processor to carry out a method according to claim 7 or 8.
